# EUROPEAN PATENT SPECIFICATION

(11) **EP 4 669 065 B1**
(45) Date of publication and mention of the grant of the patent: **08.07.2026**
(21) Application number: 25154377.3
(22) Date of filing: 28.01.2025
(51) Int. Cl.: H10H 29/24, H10H 29/852, H10H 29/855, H10H 29/856, H10H 29/80

(54) **LIGHT EMITTING DEVICE MODULE**
LICHTEMITTIERENDES VORRICHTUNGSMODUL
MODULE DE DISPOSITIF ÉLECTROLUMINESCENT

(30) Priority: 17.06.2024 KR 20240078543
(43) Date of publication of application: 24.12.2025
(73) Proprietor: Wooree E&L Co., Ltd., Ansan-si, Gyeonggi-do 15409 (KR)
(72) Inventor: LEE, Yong Jin, 15409 ANSAN-SI, Gyeonggi-do (KR); JUNG, Eui Chul, 15409 ANSAN-SI, Gyeonggi-do (KR); SHIN, Dong Jin, 15409 ANSAN-SI, Gyeonggi-do (KR)
(74) Representative: Robba, Pierpaolo

(56) References cited:
- WO-A1-2023/014100
- CN-U- 219 676 409
- US-A1- 2022 262 993
- US-A1- 2022 375 911
- US-A1- 2023 290 913

## Description

### Technical Field

The present disclosure relates to a light emitting device module applied to a display device, and more specifically, relates to a light emitting device module capable of improving uniformity of an entire light source by controlling image imbalance.

### Background

A light emitting device is a semiconductor device that uses a light emitting diode, and is widely used in various fields such as display devices, vehicle lamps, and general lighting. The light emitting diode has an advantage in that a life span is long, power consumption is low, and a response speed is fast. Accordingly, existing light sources are rapidly replaced with the light emitting device.

Meanwhile, light emitting diodes in the related art have been mainly used as backlight sources in display devices. Recently, display devices that directly implement images by using the light emitting diodes have been developed. This display is referred to as a micro LED display.

In a case of the micro LED display, micro LEDs are arrayed on a two-dimensional plane to correspond to each sub-pixel, and accordingly, a large number of the micro LEDs need to be disposed on a single substrate. However, a size of the micro LEDs is very small, for example, smaller than 200 micros or even smaller than 100 micros. Due to this small size, various problems arise. It is difficult to control the light emitting diode having the small size.

Consequently, it is not easy to directly mount the light emitting diode on a display panel. In addition, there is a problem of an image imbalance phenomenon in which light is concentrated at a center of the light emitting diode.

Korean Patent No. 10-2023-0028222 published in February 28, 2023 is an example of the related art.

US 2022/375911 discloses a light emitting device module comprising a substrate, a first reflecting layer, multiple light-emitting diode chips, and multiple optical structures. The substrate comprises a circuit structure layer. The first reflecting layer is provided on a bearing surface of the substrate, and comprises multiple through-holes provided at intervals. One of the multiple light-emitting diode chips is located in one of the multiple through-holes, and the multiple light-emitting diode chips is electrically connected to the circuit structure layer.

WO 2023/014100 discloses a lighting apparatus disclosed in an embodiment of the present invention comprises: a substrate; a plurality of light-emitting elements on the substrate; a resin layer sealing the light-emitting elements on the substrate; and a diffusion layer on the resin layer.

US 2022/262993 discloses a pixel module including a circuit board, a plurality of unit pixels arranged on the circuit board, and a molding member covering the plurality of unit pixels. The molding member includes a light diffusion layer and a black molding layer covering the light diffusion layer.

US 2023/290913 discloses a light emitting module including a substrate, light emitting elements, an encapsulant material and dimming structures. The light emitting elements are disposed over the substrate. The encapsulant material covers the light emitting elements and the substrate.

CN 219 676 409 U discloses a light source module. The light source module comprises a substrate, a light-emitting element, a packaging structure and an optical pattern. The light-emitting element is disposed on a surface of the substrate. The packaging structure is arranged on the surface of the substrate and covers the light-emitting element. The optical pattern is wrapped by the packaging structure and overlaps the light-emitting element.

### Summary

One object of the present disclosure is to provide a light emitting device module capable of solving a process control efficiency problem of a micro LED and efficiently control an image imbalance problem.

According to an aspect of the present disclosure, there is provided a light emitting device module including a circuit board 10, a semiconductor light emitting device 20 mounted on the circuit board 10, a reflective layer 30 including an opening 31 through which the

semiconductor light emitting device 20 is exposed, and covering the circuit board 10, and a molding layer 40 covering the semiconductor light emitting device 20 and the reflective layer 30. A light emitting surface of the semiconductor light emitting device 20 is formed on an upper surface facing vertically upward.

The present disclosure can improve process efficiency of a micro LED by providing the light emitting device module provided with the semiconductor light emitting device. According to the aspect of the present disclosure, efficiency of a manufacturing process can be improved, and a problem of image imbalance can be effectively controlled by applying the molding layer and the diffusion pattern layer.

### Brief Description of the Drawings

Fig. 1 is a schematic exploded perspective view of a light emitting device module according to one embodiment of the present disclosure not according to the claimed invention.
Fig. 2 is a schematic plan view of the light emitting device module according to one embodiment of the present disclosure not according to the claimed invention.
Fig. 3 is a schematic vertical cross-sectional view of the light emitting device module shown in Fig. 2.
Fig. 4 is a schematic plan view of a light emitting device module according to an embodiment according to the claimed invention.
Fig. 5 is a schematic vertical cross-sectional view of the light emitting device module shown in Fig. 4.

### Detailed Description

Hereinafter, various embodiments of the present disclosure will be described in detail with reference to the accompanying drawings. However, in describing the present disclosure, when it is determined that detailed description of a related notice function or configuration may unnecessarily obscure the concept of the present disclosure, the detailed description will be omitted.

In one specific example, the present disclosure provides a light emitting device module applied to a display device.

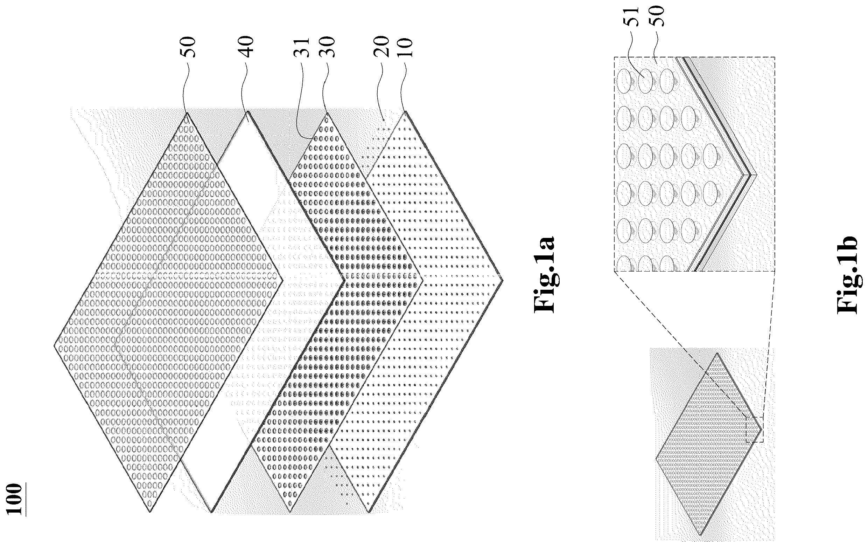

Fig. 1 is a schematic exploded perspective view of the light emitting device module according to one embodiment of the present disclosure. Specifically, Fig. 1a is an exploded perspective view of a light emitting device module 100, and Fig. 1b is a partially enlarged view of Fig. 1a.

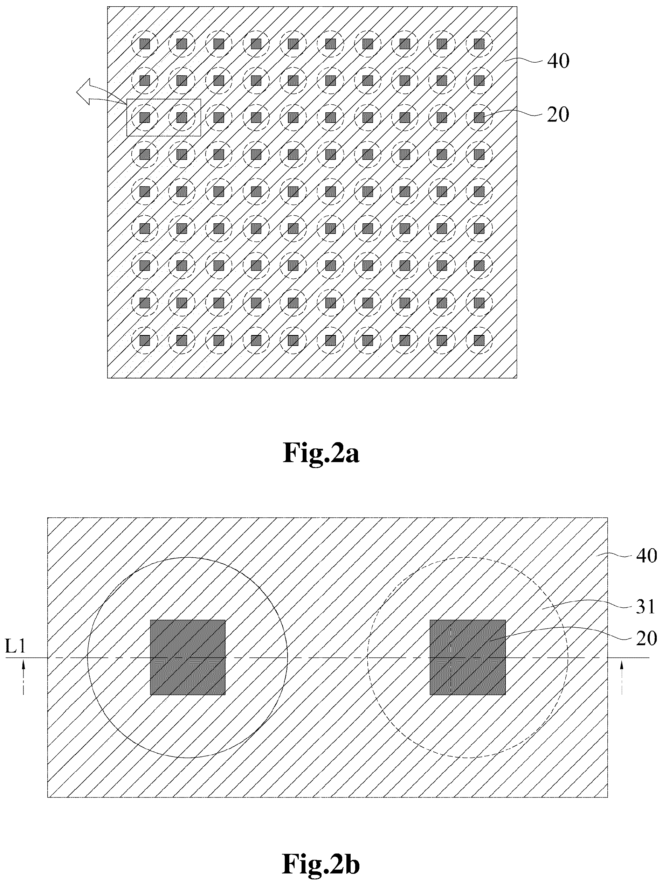

Fig. 2 is a schematic plan view of the light emitting device module according to one embodiment of the present disclosure. Specifically, Fig. 2a is a plan view of the light emitting device module 100, and Fig. 2b is a partially enlarged view of an area indicated by an arrow in Fig. 2a.

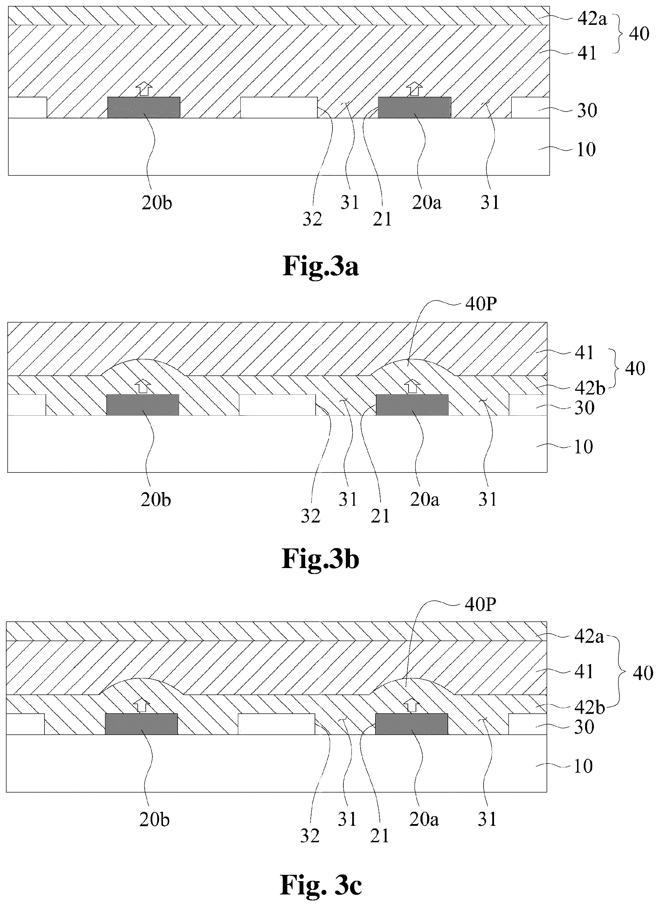

Fig. 3 is a schematic vertical cross-sectional view of the light emitting device module illustrated in Fig. 2. Specifically, Fig. 3 is a schematic vertical cross-sectional view taken along a cutting line L1 in Fig. 2b. Here, Figs. 3a, 3b, and 3c are vertical cross-sectional views of the light emitting device module according to mutually different embodiments of the present disclosure.

Referring to Figs. 1 to 3, the light emitting device module 100 of the present disclosure includes a circuit board 10, a semiconductor light emitting device 20, a reflective layer 30, and a molding layer 40.

The circuit board 10 refers to a board (PCB) on which a circuit pattern is formed, and may be formed as a flexible printed circuit board (FPCB) to ensure flexibility, for example.

The semiconductor light emitting device 20 is a part in which one or more light sources are arrayed on the circuit board 10 to emit light. Referring to Fig. 1 and Fig. 2, a plurality of the semiconductor light emitting devices 20 may be regularly aligned and disposed on the circuit board 10.

Referring to Fig. 3, the semiconductor light emitting device 20 in the present disclosure is a top view type light emitting diode in which a light emitting surface is formed on an upper surface facing vertically upward.

In a case of the top view type light emitting diode applied to the display device, there is a problem of image imbalance (for example, a hot spot) which occurs since light is concentrated in an area near the light emitting surface. According to the present disclosure, efficiency of a manufacturing process can be improved, and the problem of image imbalance can be effectively controlled by applying the molding layer 40.

The reflective layer 30 is formed on an upper surface of the circuit board 10, and is configured to cover the circuit board 10. The reflective layer 30 is formed of a material having high reflection efficiency. In this manner, since the light emitted from the semiconductor light emitting device 20 is reflected upward, the reflective layer 30 has a role to prevent a light loss.

The reflective layer 30 may be formed in a film form, and may be formed of a synthetic resin containing a white pigment to improve reflection and dispersion of the light. As the white pigment, for example, titanium oxide, aluminum oxide, zinc oxide, lead carbonate, barium sulfate, calcium carbonate, and the like may be used. Meanwhile, as the synthetic resin, for example, polyethylene terephthalate, polyethylene naphthalate, acrylic resin, polycarbonate, polystyrene, polyolefin, cellulose acetate, weather-resistant vinyl chloride, and the like may be used.

The reflective layer 30 includes an opening 31 through which the semiconductor light emitting device 20 is exposed. Accordingly, the reflective layer 30 provided with the opening 31 may be attached to the circuit board 10 on which the semiconductor light emitting device 20 is mounted. That is, description that the semiconductor light emitting device 20 is exposed by the opening 31 means that the reflective layer 30 does not cover the semiconductor light emitting device 20 in an area of the opening 31. Accordingly, even when any layer is formed on the upper surface of the semiconductor light emitting device 20, it should be interpreted that the semiconductor light emitting device 20 is exposed by the opening 31.

Meanwhile, a side surface 32 of the reflective layer 30 and a side surface 21 of the semiconductor light emitting device 20 may be in contact with or separated from each other. In terms of process efficiency, it is preferable that the side surface 32 of the reflective layer 30 and the side surface 21 of the semiconductor light emitting device 20 are disposed to be separate from each other.

The molding layer 40 is formed in an upper portion of the semiconductor light emitting device 20 and the reflective layer 30, and is configured to cover the semiconductor light emitting device 20 and the reflective layer 30. The molding layer 40 guides the light emitted from the semiconductor light emitting device 20 to be directed forward. Meanwhile, the molding layer 40 may cover an upper portion of the circuit board 10. Here, the molding layer 40 may be configured to cover the upper portion of the circuit board 10 by coming into contact with or being separated from the upper surface of the circuit board 10.

A material of the molding layer 40 may be a light-transmitting thermoplastic resin, and for example, may be an epoxy resin or a silicone resin.

The molding layer 40 may be formed by using techniques such as lamination, spin coating, slit coating, and printing. For example, the molding layer 40 may be formed on the semiconductor light emitting device 20 by using a technique of vacuum lamination after bonding a heat-resistant layer 41 and a light diffusion layer 42 (to be described later). Specifically, in the present disclosure, a temperature of the vacuum lamination may be 90°C to 130°C, and a pressurizing pressure may be 150 Kgf to 500 Kgf.

In one specific example, referring to Fig. 3, the molding layer 40 of the present disclosure includes the heat-resistant layer 41 and the light diffusion layer 42.

The heat-resistant layer 41 is formed of a high heat-resistant material, and has a role to protect the semiconductor light emitting device 20 from an external environment. For example, as described above, the high heat-resistant material may be an epoxy resin or a silicone resin.

The light diffusion layer 42 has a role to guide the light emitted from the semiconductor light emitting device 20 to be diffused forward.

In one specific example, the light diffusion layer 42 is provided on at least one of an upper surface and a lower surface of the heat-resistant layer 41. Fig. 3a shows an example in which the light diffusion layer 42a is provided on the upper surface of the heat-resistant layer 41, Fig. 3b shows an example in which the light diffusion layer 42b is provided on the lower surface of the heat-resistant layer 41, and Fig. 3c shows an example in which the light diffusion layers 42a and 42b are provided on the upper surface and the lower surface of the heat-resistant layer 41.

In one specific example, the light diffusion layer 42 includes a material which enables the light to be diffused into a transparent medium, for example, such as an epoxy resin. In the present disclosure, the light diffusion layer 42 may include a plurality of particles internally having hollow portions (or pores). The particles have a role to improve reflection and diffusion properties of the light.

In the present disclosure, the particles included in the light diffusion layer 42 may be formed of any one selected from silicon, silica, glass bubbles, polymethyl methacrylate (PMMA), urethane, Zn, Zr, Al₂O₃, and acrylic. Meanwhile, a particle diameter of the particles may be formed in a range of 1 µm to 20 µm, but the example is not limited thereto.

In one specific example, referring to Fig. 3a, when the light diffusion layer 42a is provided on the upper surface of the heat-resistant layer 41, the heat-resistant layer 41 fills at least a portion of the opening 31. Meanwhile, referring to Figs. 3b and 3c, when the light diffusion layer 42b is provided on the lower surface of the heat-resistant layer 41, the light diffusion layer 42b fills at least a portion of the opening 31.

As described above, the reflective layer 30 includes the opening 31 through which the semiconductor light emitting device 20 is exposed. Accordingly, the side surface 32 of the reflective layer 30 and the side surface 21 of the semiconductor light emitting device 20 may be disposed to be separate from each other.

Here, for example, when the molding layer 40 is formed by using the technique of the vacuum lamination, the molding layer 40 may be formed such that the light diffusion layer 42b or the heat-resistant layer 41 fills at least a portion of the opening 31. In particular, by filling the opening 31 with the light diffusion layer 42b, the light emitted from the side surface of the semiconductor light emitting device 20 may be guided to be effectively diffused forward (that is, vertically upward in Fig. 3).

In one specific example, referring to Figs. 3b and 3c, when the light diffusion layer 42b is provided on the lower surface of the heat-resistant layer 41, the light diffusion layer 42b includes a step region 40P covering each of the plurality of the semiconductor light emitting devices 20a and 20b. Here, the step region 40P is configured to protrude upward. That is, the step region 40P may be configured to protrude upward from a horizontal plane of the light diffusion layer 42b. Since the light diffusion layer 42b includes the step region 40P covering each of the plurality of the semiconductor light emitting devices 20a and 20b, a directional angle of the light emitted from the semiconductor light emitting devices 20a and 20b may be increased to control the problem of image imbalance.

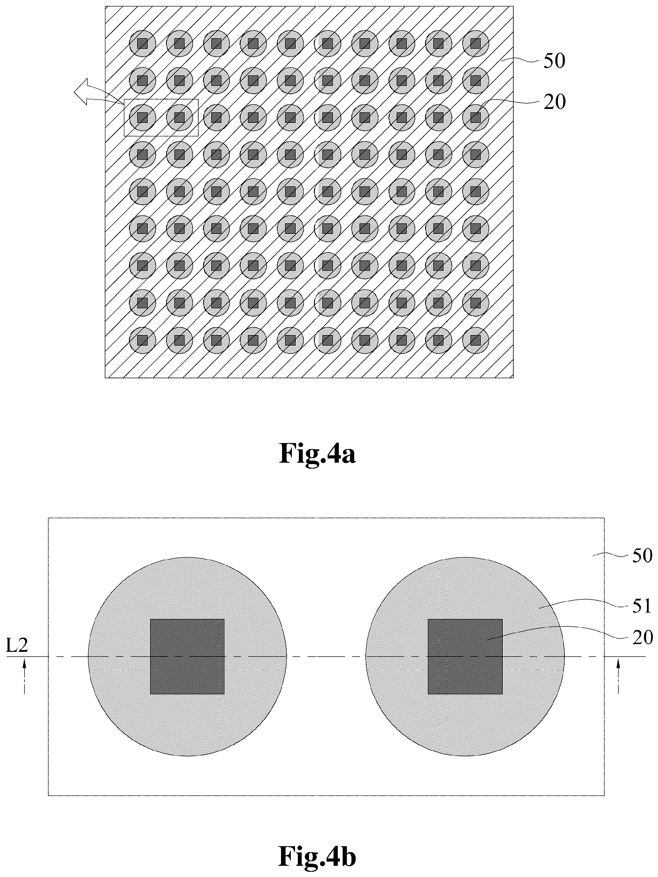

Fig. 4 is a schematic plan view of a light emitting device module according to an embodiment according to the claimed invention. Specifically, Fig. 4a is a plan view of the light emitting device module, and Fig. 4b is a partially enlarged view of an area indicated by an arrow in Fig. 4a.

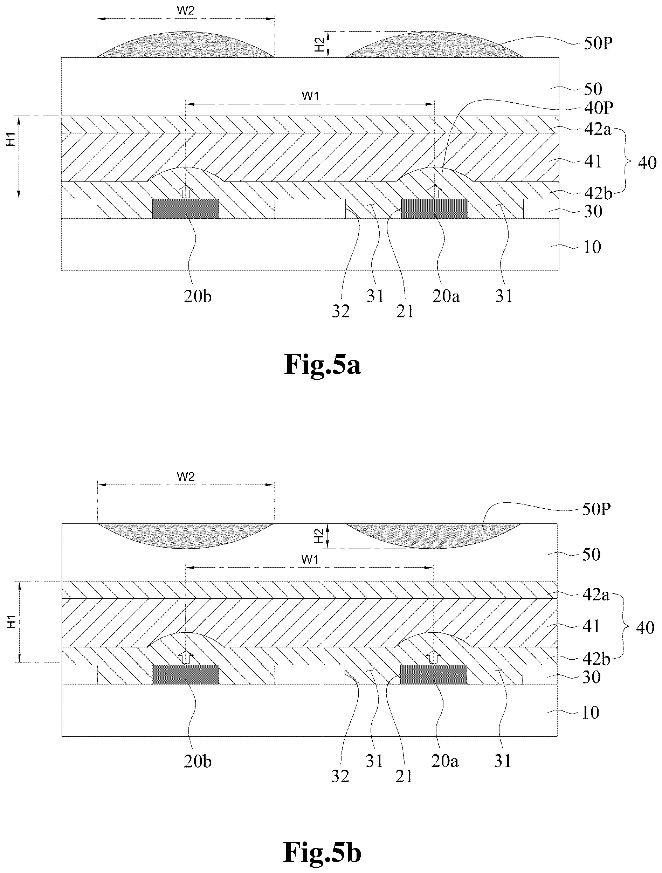

Fig. 5 is a schematic vertical cross-sectional view of the light emitting device module illustrated in Fig. 4. Specifically, Fig. 5 is a schematic vertical cross-sectional view taken along a cutting line L2 in Fig. 4b. Here, Figs. 5a and 5b are vertical cross-sectional views of the light emitting device module according to mutually different embodiments of the present disclosure.

In one specific example, referring to Figs. 4 and 5, the light emitting device module of the present disclosure further includes a diffusion pattern layer 50 covering the molding layer 40. Specifically, the diffusion pattern layer 50 is formed in an upper portion of the molding layer 40, and is configured to cover the molding layer 40.

The diffusion pattern layer 50 may be formed of a synthetic resin, for example, such as polyethylene terephthalate, polyethylene naphthalate, acrylic resin, polycarbonate, polystyrene, polyolefin, cellulose acetate, and weather-resistant polyvinyl chloride.

In one specific example, the diffusion pattern layer 50 includes a pattern area 50P covering the semiconductor light emitting device 20, and the pattern area 50P includes a light diffusing material or a light absorbing material.

The pattern area 50P may control the problem of image imbalance in such a manner that a light diffusing material is used to increase the directional angle by diffusing the light emitted from the semiconductor light emitting device 20, or may control the problem of image imbalance in such a manner that a light absorbing material is used to absorb the light.

In the present disclosure, for example, the light diffusing material included in the pattern area 50P may be one or more materials selected from TiO₂, CaCO₃, BaSO₄, Al₂O₃, and silicon.

The light absorbing material included in the pattern area 50P in the present disclosure may include a light absorbing dye, for example, such as carbon black. The light absorbing dye may be directly dispersed into a medium, or may be coated on a surface of organic or inorganic particles to be dispersed into the medium. Various types of organic or inorganic particles may be used to coat the light absorbing material. For example, particles obtained by coating TiO2 or silica particles with the carbon black may be used.

The pattern area 50P may be formed by applying ink containing the light diffusing material or the light absorbing material to an upper surface of a polymer film in an emitting direction of the light, for example, by using a screen printer method.

In one specific example, the pattern area 50P may be configured such that a concentration of the light diffusing material or the light absorbing material decreases as the pattern area 50P is directed away from the center. The pattern area 50P is configured such that the concentration of the light diffusing material or the light absorbing material becomes higher at the center of the pattern area 50P, and light transmittance is reduced at the center of the pattern area 50P. In this manner, the problem of image imbalance caused by light concentration in a center region of the light emitting surface of the semiconductor light emitting device 20 may be effectively controlled.

In one specific example, the pattern area 50P is formed in a circular shape around the semiconductor light emitting device 20 covered by the pattern area 50P, and the pattern area 50P is configured such that a thickness decreases as the pattern area 50P is directed away from the center of the circular shape.

Since the pattern area 50P is formed in the circular shape around the semiconductor light emitting device 20, the light emitted from the semiconductor light emitting device 20 may be effectively covered and controlled.

In addition, since the thickness at the center of the pattern area 50P is formed to be largest, the problem of image imbalance may be effectively controlled by reducing the light transmittance at the center of the pattern area 50P.

In one specific example, the pattern area 50P has an upper surface having a convex curved shape, and is configured to protrude upward from a horizontal plane of the diffusion pattern layer 50 adjacent to the pattern area 50P.

In one specific example, the pattern area 50P has a lower surface having a concave curved shape, and is configured to be recessed downward from the horizontal plane of the diffusion pattern layer 50.

The pattern area 50P may form patterns of various shapes, such as squares and polygons as well as the above-described circular shape. In this case, the pattern area 50P is configured to protrude upward while the upper surface has the convex curved shape, or to be recessed downward while the lower surface has the concave curved shape. In this manner, the problem of image imbalance may be effectively controlled by reducing the light transmittance at the center of the pattern area 50P.

In one specific example, the light emitting device module 100 of the present disclosure is configured such that a width W2 of the pattern area 50P is smaller than a distance W1 between the centers of two adjacent semiconductor light emitting devices 20a and 20b. Referring to Fig. 3, since the width W2 of the pattern area 50P is configured to be smaller than the distance W1 between the centers of the two adjacent semiconductor light emitting devices 20a and 20b, a plurality of the pattern areas 50P may be disposed to be separate from each other without overlapping each other. Accordingly, whereas the pattern area 50P is disposed to cover each of the semiconductor light emitting devices 20a and 20b, the pattern area 50P does not exist in a space between the semiconductor light emitting devices 20a and 20b. Therefore, the problem of image imbalance may be controlled by adjusting the light transmittance of the light emitting device module 100 as a whole.

In one specific example, the light emitting device module 100 of the present disclosure is configured such that a height H2 of the pattern area 50P is lower than a height H1 of the molding layer 40. When the height H2 of the pattern area 50P is too high, the light emitted from each of the semiconductor light emitting devices 20a and 20b may be blocked too much. Consequently, a problem may arise in that a light output at the center of each of the semiconductor light emitting devices 20a and 20b may be reduced compared to a periphery thereof.

### Detailed Description of Main Elements

10: circuit board
20: semiconductor light emitting device
30: reflective layer
40: molding layer
50: diffusion pattern layer

## Claims

1. A light emitting device module (100) comprising:
a circuit board (10);
a semiconductor light emitting device (20) mounted on the circuit board (10);
a reflective layer (30) including an opening (31) through which the semiconductor light emitting device (20) is exposed, and covering the circuit board (10); and
a molding layer (40) covering the semiconductor light emitting device (20) and the reflective layer (30),
wherein a light emitting surface of the semiconductor light emitting device (20) is formed on an upper surface facing vertically upward,
wherein the light emitting device module (100) further comprises a diffusion pattern layer (50) covering the molding layer (40),
wherein the diffusion pattern layer (50) includes a pattern area (50P) covering the semiconductor light emitting device (20), and
**characterized in that**
the pattern area (50P) includes a light absorbing material, wherein,
in the pattern area (50P), a concentration of the light absorbing material decreases as the pattern area (50P) is directed away from a center of the pattern area (50P).

2. The light emitting device module (100) of claim 1, wherein the molding layer (40) includes a heat-resistant layer (41) and a light diffusion layer (42),
wherein the heat-resistant layer (41) is formed of an epoxy resin or a silicone resin.

3. The light emitting device module (100) of claim 2, wherein the light diffusion layer (42) is provided on at least one of an upper surface and a lower surface of the heat-resistant layer (41).

4. The light emitting device module (100) of claim 2, wherein the light diffusion layer (42) includes particles made of one selected from silicon, silica, glass bubbles, polymethyl methacrylate (PMMA), urethane, Zn, Zr, Al₂O₃, and acrylic.

5. The light emitting device module (100) of claim 3, wherein when the light diffusion layer (42) is provided on the upper surface of the heat-resistant layer (41), the heat-resistant layer (41) fills at least a portion of the opening (31), and when the light diffusion layer (42) is provided on the lower surface of the heat-resistant layer (41), the light diffusion layer (42b) fills at least a portion of the opening 31.

6. The light emitting device module (100) of claim 3, wherein when the light diffusion layer (42) is provided on the lower surface of the heat-resistant layer (41), the light diffusion layer (42) includes a step region (40P) covering the semiconductor light emitting device (20), and the step region (40P) is configured to protrude upward.

7. The light emitting device module (100) of claim 1, wherein the pattern area (50P) is formed in a circular shape around the semiconductor light emitting device (20) covered by the pattern area (50P), and a thickness of the pattern area (50P) decreases as the pattern area (50P) is directed away from a center of the circular shape.

8. The light emitting device module (100) of claim 1, wherein the pattern area (50P) has an upper surface having a convex curved shape, and is configured to protrude upward from a horizontal plane of the diffusion pattern layer (50) adjacent to the pattern area (50P).

9. The light emitting device module (100) of claim 1, wherein the pattern area (50P) has a lower surface of a concave curved shape, and is configured to be recessed downward from a horizontal plane of the diffusion pattern layer (50).

10. The light emitting device module (100) of claim 1, wherein a width (W2) of the pattern area (50P) is smaller than a distance (W1) between centers of two adjacent semiconductor light emitting devices (20a) and (20b).

11. The light emitting device module (100) of claim 1, wherein a height (H2) of the pattern area (50P) is lower than a height (H1) of the molding layer (40).

## Patentansprüche

1. Lichtemittierendes Vorrichtungsmodul (100) umfassend:
eine Leiterplatte (10);
eine lichtemittierende Halbleitervorrichtung (20), die auf der Leiterplatte (10) montiert ist;
eine die Leiterplatte (10) bedeckende Reflexionsschicht (30), die eine Öffnung (31) aufweist,
durch die die lichtemittierende Halbleitervorrichtung (20) freiliegt; und
eine Umspritzschicht (40), die die lichtemittierende Halbleitervorrichtung (20) und die Reflexionsschicht (30) bedeckt,
wobei eine lichtemittierende Oberfläche der lichtemittierenden Halbleitervorrichtung (20) auf einer senkrecht nach oben zeigende Oberseite ausgebildet ist,
wobei das lichtemittierendes Vorrichtungsmodul (100) weiter eine die Umspritzschicht (40) bedeckende Diffusionsmusterschicht (50) umfasst,
wobei die Diffusionsmusterschicht (50) einen die lichtemittierende Halbleitervorrichtung (20) bedeckenden Musterbereich (50P) umfasst, und
**dadurch gekennzeichnet, dass**
der Musterbereich (50P) ein lichtabsorbierendes Material enthält,
wobei, in dem Musterbereich (50P), die Konzentration des lichtabsorbierenden Materials nimmt ab, je weiter der Musterbereich (50P) vom Zentrum des Musterbereichs (50P) entfernt ist.

2. Lichtemittierendes Vorrichtungsmodul (100) nach Anspruch 1, wobei die Umspritzschicht (40) eine wärmebeständige Schicht (41) und eine Lichtdiffusionsschicht (42) umfasst,
wobei die wärmebeständige Schicht (41) aus einem Epoxidharz oder einem Silikonharz besteht.

3. Lichtemittierendes Vorrichtungsmodul (100) nach Anspruch 2, wobei die Lichtdiffusionsschicht (42) mindestens auf einer Oberseite und/oder einer Unterseite der wärmebeständigen Schicht (41) vorgesehen ist.

4. Lichtemittierendes Vorrichtungsmodul (100) nach Anspruch 2, wobei die Lichtdiffusionsschicht (42) Partikel enthält, die aus einem Material bestehen, das aus Silizium, Kieselsäure, Glasblasen, Polymethylmethacrylat (PMMA), Urethan, Zn, Zr, Al₂O₃ und Acryl ausgewählt ist.

5. Lichtemittierendes Vorrichtungsmodul (100) nach Anspruch 3, wobei, wenn die Lichtdiffusionsschicht (42) auf der Oberseite der wärmebeständigen Schicht (41) vorgesehen ist, die wärmebeständige Schicht (41) zumindest einen Teil der Öffnung (31) ausfüllt, und, wenn die Lichtdiffusionsschicht (42) auf der Unterseite der wärmebeständigen Schicht (41) vorgesehen ist, die Lichtdiffusionsschicht (42b) zumindest einen Teil der Öffnung (31) ausfüllt.

6. Lichtemittierendes Vorrichtungsmodul (100) nach Anspruch 3, wobei, wenn die Lichtdiffusionsschicht (42) auf der Unterseite der wärmebeständigen Schicht (41) vorgesehen ist, die Lichtdiffusionsschicht (42) einen abgestuften Bereich (40P) umfasst, der die lichtemittierende Halbleitervorrichtung (20) bedeckt, und der abgestufte Bereich (40P) so konfiguriert ist, dass er nach oben vorsteht.

7. Lichtemittierendes Vorrichtungsmodul (100) nach Anspruch 1, wobei der Musterbereich (50P) mit einer kreisförmigen Form um die durch den Musterbereich (50P) bedeckte lichtemittierende Halbleitervorrichtung (20) geformt ist, und eine Dicke des Musterbereichs (50P) abnimmt, je weiter der Musterbereich (50P) vom Zentrum der kreisförmigen Form entfernt ist.

8. Lichtemittierendes Vorrichtungsmodul (100) nach Anspruch 1, wobei der Musterbereich (50P) eine Oberseite mit einer konvex gewölbten Form aufweist und so konfiguriert ist, dass er von einer horizontalen Ebene der dem Musterbereich (50P) benachbarten Diffusionsmusterschicht (50) nach oben vorsteht.

9. Lichtemittierendes Vorrichtungsmodul (100) nach Anspruch 1, wobei der Musterbereich (50P) eine Unterseite mit einer konkav gewölbten Form aufweist und so konfiguriert ist, dass er von einer horizontalen Ebene der Diffusionsmusterschicht (50) nach unten vertieft ist.

10. Lichtemittierendes Vorrichtungsmodul (100) nach Anspruch 1, wobei eine Breite (W2) des Musterbereichs (50P) kleiner ist als der Abstand (W1) zwischen Zentren zweier benachbarter lichtemittierender Halbleitervorrichtungen (20a) und (20b).

11. Lichtemittierendes Vorrichtungsmodul (100) nach Anspruch 1, wobei eine Höhe (H2) des Musterbereichs (50P) kleiner ist als eine Höhe (H1) der Umspritzschicht (40).

## Revendications

1. Module de dispositif d'émission de lumière (100) comprenant :
une carte de circuit imprimé (10);
un dispositif d'émission de lumière à semi-conducteur (20) monté sur la carte de circuit imprimé (10);
une couche réfléchissante (30) comportant une ouverture (31) à travers laquelle le dispositif d'émission de lumière à semi-conducteur (20) est exposé, cette couche réfléchissante recouvrant la carte de circuit imprimé (10) ; et
une couche de moulage (40) recouvrant le dispositif d'émission de lumière à semi-conducteur (20) et la couche réfléchissante (30),
dans lequel une surface d'émission de lumière du dispositif d'émission de lumière à semi-conducteur (20) est formée sur une surface supérieure orientée verticalement vers le haut,
dans lequel le module de dispositif d'émission de lumière (100) comprend en outre une couche de motif de diffusion (50) recouvrant la couche de moulage (40),
dans lequel la couche de motif de diffusion (50) comprend une zone de motif (50P) recouvrant le dispositif d'émission de lumière à semi-conducteur (20), et
**caractérisé en ce que** la zone de motif (50P) comprend un matériau absorbant la lumière,
dans lequel, dans la zone de motif (50P), la concentration du matériau absorbant la lumière diminue à mesure que la zone de motif (50P) s'éloigne du centre de la zone de motif (50P).

2. Module de dispositif d'émission de lumière (100) selon la revendication 1, dans lequel la couche de moulage (40) comprend une couche résistante à la chaleur (41) et une couche de diffusion de lumière (42), la couche résistante à la chaleur (41) étant formée d'une résine époxy ou d'une résine de silicone.

3. Module de dispositif d'émission de lumière (100) selon la revendication 2, dans lequel la couche de diffusion de lumière (42) est prévue sur au moins une parmi une surface supérieure et une surface inférieure de la couche résistante à la chaleur (41).

4. Module de dispositif d'émission de lumière (100) selon la revendication 2, dans lequel la couche de diffusion de lumière (42) comprend des particules constituées d'un matériau choisi parmi le silicium, la silice, les bulles de verre, le polyméthacrylate de méthyle (PMMA), l'uréthane, le Zn, le Zr, l'Al₂O₃ et l'acrylique.

5. Module de dispositif d'émission de lumière (100) selon la revendication 3, dans lequel, lorsque la couche de diffusion de lumière (42) est prévue sur la surface supérieure de la couche résistante à la chaleur (41), la couche résistante à la chaleur (41) remplit au moins une partie de l'ouverture (31), et lorsque la couche de diffusion de lumière (42) est prévue sur la surface inférieure de la couche résistante à la chaleur (41), la couche de diffusion de lumière (42b) remplit au moins une partie de l'ouverture (31).

6. Module de dispositif d'émission de lumière (100) selon la revendication 3, dans lequel, lorsque la couche de diffusion de lumière (42) est prévue sur la face inférieure de la couche résistante à la chaleur (41), la couche de diffusion de lumière (42) comprend une zone en gradin (40P) recouvrant le dispositif d'émission de lumière à semi-conducteur (20), et la zone en gradin (40P) est configurée pour faire saillie vers le haut.

7. Module de dispositif d'émission de lumière (100) selon la revendication 1, dans lequel la zone de motif (50P) est formée en une forme circulaire autour du dispositif d'émission de lumière à semi-conducteur (20) recouvert par la zone de motif (50P), et l'épaisseur de la zone de motif (50P) diminue à mesure que la zone de motif (50P) s'éloigne du centre de la forme circulaire.

8. Module de dispositif d'émission de lumière (100) selon la revendication 1, dans lequel la zone de motif (50P) présente une surface supérieure de forme courbe convexe et est configurée pour faire saillie vers le haut à partir d'un plan horizontal de la couche de motif de diffusion (50) adjacente à la zone de motif (50P).

9. Module de dispositif d'émission de lumière (100) selon la revendication 1, dans lequel la zone de motif (50P) présente une surface inférieure de forme courbe concave et est configurée pour être en retrait vers le bas par rapport à un plan horizontal de la couche de motif de diffusion (50).

10. Module de dispositif d'émission de lumière (100) selon la revendication 1, dans lequel une largeur (W2) de la zone de motif (50P) est inférieure à une distance (W1) entre les centres de deux dispositifs d'émission de lumière à semi-conducteur (20a) et (20b) adjacents.

11. Module de dispositif d'émission de lumière (100) selon la revendication 1, dans lequel une hauteur (H2) de la zone de motif (50P) est inférieure à une hauteur (H1) de la couche de moulage (40).
